Europäisches Patentamt

European Patent Office

Office européen des brevets

(19)

(11) Publication number: **0 400 666**
**A2**

(12) **EUROPEAN PATENT APPLICATION**

(21) Application number: **90110464.6**

(22) Date of filing: **01.06.90**

(51) Int. Cl.⁵: **H01L 39/12**

(30) Priority: **02.06.89 JP 141418/89**
**21.06.89 JP 159023/89**

(43) Date of publication of application:
**05.12.90 Bulletin 90/49**

(84) Designated Contracting States:
**DE FR GB NL**

(71) Applicant: **TODA KOGYO CORP.**
**7-1 Yokogawa-Shinmachi Nishi-ku**
**Hiroshima-shi Hiroshima-ken(JP)**

Applicant: **NEC CORPORATION**
**33-1, Shiba 5-chome**
**Minato-ku Tokyo-to(JP)**

Applicant: **SEISAN KAIHATSU KAGAKU KENKYUSHO**
**15, Shimogamo Morimoto-cho**
**Sakyo-ku Kyoto-shi Kyoto-fu(JP)**

(72) Inventor: **Takada, Toshio**

**1, Nishisenouchi-cho, Kitashirakawa**
**Sakyo-ku, Kyoto-shi, Kyoto-fu(JP)**
Inventor: **Takano, Mikio**
**17, Yasuihigashiura-cho, Uzumasa, Ukyo-ku**
**Kyoto-shi, Kyoto-fu(JP)**
Inventor: **Miura, Yoshinari**
**1155, Takeman, Kamigoori-cho**
**Ako-bun, Hyogo-ken(JP)**
Inventor: **Takada, Jun**
**1-14-10, Shimizu**
**Okayama-shi, Okayama-ken(JP)**
Inventor: **Oda, Kiichi**
**2-3-19, Showa**
**Kurashiki-shi, Okayama-ken(JP)**
Inventor: **Yamamoto, Naoichi**
**D-17-203, Satakedai Haitu, 1-2, Satakedai**
**Suita-shi, Osaka-fu(JP)**

(74) Representative: **Vossius & Partner**
**Siebertstrasse 4 P.O. Box 86 07 67**
**D-8000 München 86(DE)**

(54) **Bi-Pb-Sr-Ca-Cu-O system superconductors.**

(57) A Bi-Pb-Sr-Ca-Cu-O system superconductor having a composition of
$Bi_n Pb_m Sr_x Ca_y Cu_2$
wherein n is a number from 0.75 to 1.05, m is a number from 0.01 to 0.20, x is a number from 0.85 to 1.35 and y is a number from 1.00 to 1.35, or n is a number larger than 1.05 and not larger than 1.15, m is a number from 0.12 to 0.25, x is a number from 1.20 to 1.35 and y is a number from 1.20 to 1.35, when they are normalized with the Cu mole number of 2, which has $T_c$ of at least 107 K or 108 K.

## Bi-Pb-Sr-Ca-Cu-O SYSTEM SUPERCONDUCTORS

The present invention relates to Bi-Pb-Sr-Ca-Cu-O system superconductors which have a zero resistance critical temperature ($T_c$) of at least 107 K or 108 K, in some cases, at least 110 K.

In 1988, the researchers in the National Institute for Metals, Japan found a Bi-Sr-Ca-Cu-O system superconductor having $T_c$ of 105 K which was obtained by extrapolation of the measured date. However, hitherto, it has been believed that it is very difficult to produce a Bi-Sr-Ca-Cu-O system superconductor which has $T_c$ of 105 K or higher and contains a high $T_c$ phase in a large volume percentage with good reproducibility.

The present inventors synthesized a superconductor comprising a Bi-Sr-Ca-Cu-O system to which Pb is added and found that such new Bi-Pb-Sr-Ca-Cu-O system superconductor had $T_c$ of 107 K. However, it is still difficult to produce the Bi-Pb-Sr-Ca-Cu-O system superconductor having $T_c$ of 107 or higher and containing the high $T_c$ phase in a larger volume percentage with good reproducibility. Very few scientists have been able to synthesize such superconductor.

The Y-Ba-Cu-O system superconductor which was found in 1987, the Bi-Sr-Ca-Cu-O system superconductor and the Bi-Pb-Sr-Ca-Cu-O system superconductor have $T_c$ higher than the liquid nitrogen temperature, namely 77 K and attract great attention worldwidely. But, it is still desired to provide a superconductor having higher $T_c$ since when difference between the liquid nitrogen temperature and $T_c$ is greater, the superconductor has better and more stable superconductive characteristics.

One object of the present invention is to provide a Bi-Pb-Sr-Ca-Cu-O system superconductor having higher $T_c$.

Another object of the present invention is to provide a Bi-Pb-Sr-Ca-Cu-O system superconductor which can be synthesized with good reproducibility.

These and other objects are achieved by a Bi-Pb-Sr-Ca-Cu-O system superconductor having a composition of
$Bi_nPb_mSr_xCa_yCu_2$
wherein n is a number from 0.75 to 1.05, m is a number from 0.01 to 0.20, x is a number from 0.85 to 1.35 and y is a number from 1.00 to 1.35, or n is a number larger than 1.05 and not larger than 1.15, m is a number from 0.12 to 0.25, x is a number from 1.20 to 1.35 and y is a number from 1.20 to 1.35, when they are normalized with the Cu mole number of 2.

Fig. 1 is a graph showing the temperature dependence of the electrical resistance of the sample prepared in Example 1,

Fig. 2 shows the A.C. magnetic susceptibility of the sample prepared in Example 1,

Fig. 3 shows the X-ray diffraction pattern of the sample prepared in Example 1,

Fig. 4 is a graph showing the temperature dependence of the electrical resistance of the sample prepared in Example 2,

Fig. 5 shows the A.C. magnetic susceptibility of the sample prepared in Example 2,

Fig. 6 shows the X-ray diffraction pattern of the sample prepared in Example 2,

Fig. 7 is a graph showing the temperature dependence of the electrical resistance of the sample prepared in Example 9,

Fig. 8 shows the X-ray diffraction pattern of the sample prepared in Example 9,

Fig. 9 is a graph showing the temperature dependence of the electrical resistance of the sample prepared in Example 10,

Fig. 10 shows the A.C. magnetic susceptibility of the sample prepared in Example 10, and

Fig. 11 shows the X-ray diffraction pattern of the sample prepared in Example 10.

In the first embodiment, the Bi-Pb-Sr-Ca-Cu-O system superconductor of the present invention has a composition of
$Bi_nPb_mSr_xCa_yCu_2$
wherein n is a number from 0.75 to 1.05, m is a number from 0.01 to 0.20, x is a number from 0.85 to 1.35 and y is a number from 1.00 to 1.35. With this composition, the Bi-Pb-Sr-Ca-Cu-O system superconductor has $T_c$ of 107 K or higher and contains the high $T_c$ phase in a larger volume percentage and can be synthesized with good reproducibility. When n is a number from 0.80 to 0.95, m is a number from 0.04 to 0.20, x is a number from 0.90 to 1.30 and y is a number from 1.00 to 1.30, the superconductor has $T_c$ of 110 K or higher and contains the high $T_c$ phase in a large volume percentage.

In the second embodiment, the superconductor of the present invention has a composition of
$Bi_nPb_mSr_xCa_yCu_2$
wherein n is a number larger than 1.05 and not larger than 1.15, m is a number from 0.12 to 0.25, x is a number from 1.20 to 1.35 and y is a number from 1.20 to 1.35. With this composition, the Bi-Pb-Sr-Ca-Cu-O system superconductor has $T_c$ of 108 K or higher and contains the high $T_c$ phase in a larger volume percentage and can be synthesized with good reproducibility. Preferably, n is a number larger than 1.05 and not larger than 1.12, m is a number from 0.15 to 0.23, x is a number from 1.25 to 1.35 and y is a number from 1.25 to 1.35.

The superconductive compound of the present invention can be produced as follows:

First, as raw materials, $Bi_2O_3$, $SrCO_3$, $CaCO_3$, CuO and PbO are weighed in a desired molar ratio and mixed, or carboxylates such as oxalates containing Bi, Pb, Sr, Ca and Cu in a desired molar ratio are synthesized by a coprecipitation method. In this step, the molar ratio of Bi, Sr, Ca and Cu may be almost the same as that in the final product, while Pb may be used in a ratio more than that in the final product since a part of Pb is evaporated during thermal treatment.

When the mole number of Cu is 2, the preferred molar ratios of other elements in the raw material are, in the first embodiment,
$0.76 < n < 1.15$,
$0.25 < m < 0.60$,
$1.00 < x < 1.40$ and
$1.00 < y < 1.40$,
or in the second embodiment,
$1.00 < n < 1.20$,
$0.15 < m < 0.60$,
$1.15 < x < 1.40$ and
$1.15 < y < 1.40$.

Then, the oxide mixture or the carboxylate mixture is heated and reacted in the air at about 800°C. When the carboxylates are used, preferably the mixture is thermally decomposed at about 250°C and then reacted at about 800°C. The heated mixture is ground and pelletized under pressure of about 500 to 1000 $kg/cm^2$. Finally, the pellet is sintered at a temperature of 845 to 865°C.

The present invention will be illustrated by following Examples.

Example 1

To a solution of nitrates of Bi, Pb, Sr, Ca and Cu, ammonium oxalate was added to coprecipitate oxalates in which the molar ratio of Bi:Pb:Sr:Ca:Cu was 0.90:0.51:1.18: 1.18:2.00. The coprecipitated oxalates were dried at 100°C, heated at 250°C to decompose them and ground followed by heating with an electric furnace in the air at 800°C for 12 hours. Thereafter, the mixture was again ground and pressed under pressure of about 1000 $kg/cm^2$ to produce a pellet of 20 mm in diameter and 2 mm in thickness. The pellet was sintered with the electric furnace in the air at 855°C for 120 hours.

With the sintered sample, the molar ratio of the component elements was examined with ICAP to find that the molar ratio of Bi:Pb:Sr:Ca:Cu was 0.85:0.10:1.15:1.13:2.00 when normalized with the mole number of Cu of 2.

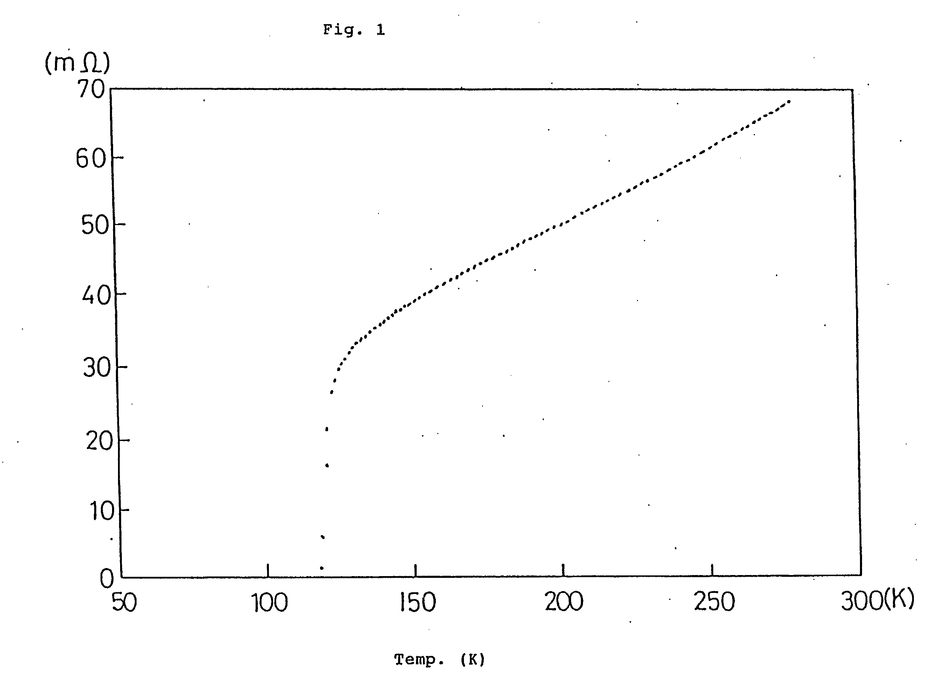

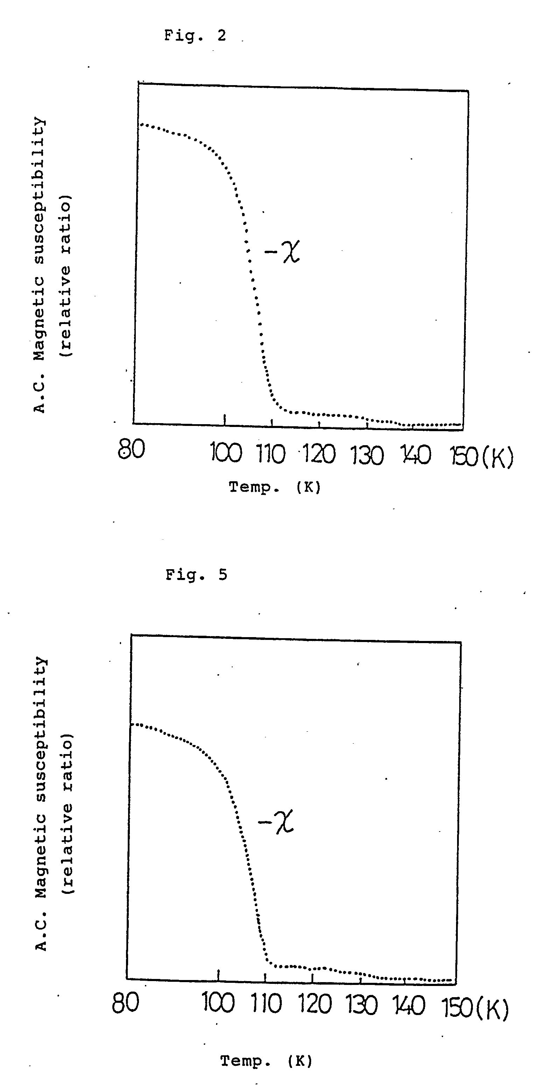

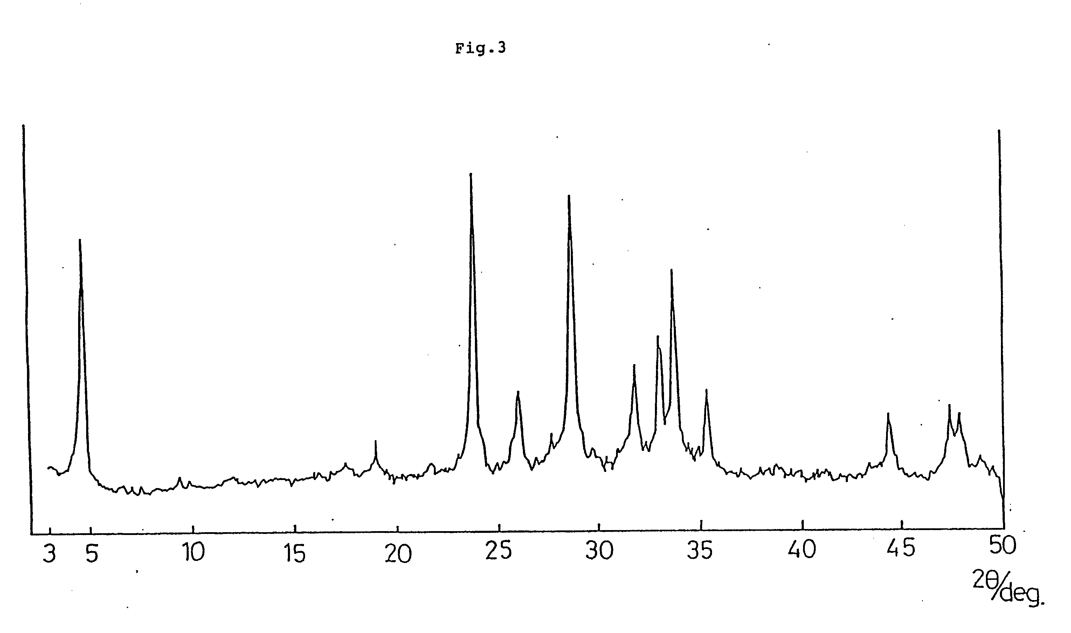

The temperature dependence of the electrical resistance of this sample is shown in Fig. 1, from which it is understood that the electrical resistance quickly dropped from about 130 K and reached 0 (zero) at about 115 K. The A.C. magnetic susceptibility of this sample is shown in Fig. 2, which confirms that this sample could be superconductive at about 115 K or higher. The X-ray diffraction pattern of this sample is shown in Fig. 3, which indicates that the percentage of the high $T_c$ phase with the c axis of 37 Å in this sample was substantially 100 %.

Example 2

To a solution of nitrates of Bi, Pb, Sr, Ca and Cu, ammonium oxalate was added to coprecipitate oxalates in which the molar ratio of Bi:Pb:Sr:Ca:Cu was 0.88:0.45:1.20: 1.20:2.00. The coprecipitated oxalates were dried at 100°C, heated at 500°C to decompose them and ground followed by heating with an electric furnace in the air at 800°C for 12 hours. Thereafter, the mixture was again ground and pressed under pressure of about 600 $kg/cm^2$ to produce a pellet of 20 mm in diameter and 2 mm in thickness. The pellet was sintered with the electric furnace in the air at 844°C for 192 hours.

With the sintered sample, the molar ratio of the component elements was examined with ICAP to find that the molar ratio of Bi:Pb:Sr:Ca:Cu was 0.81:0.07:1.16:1.15:2.00 when normalized with the mole number of Cu of 2.

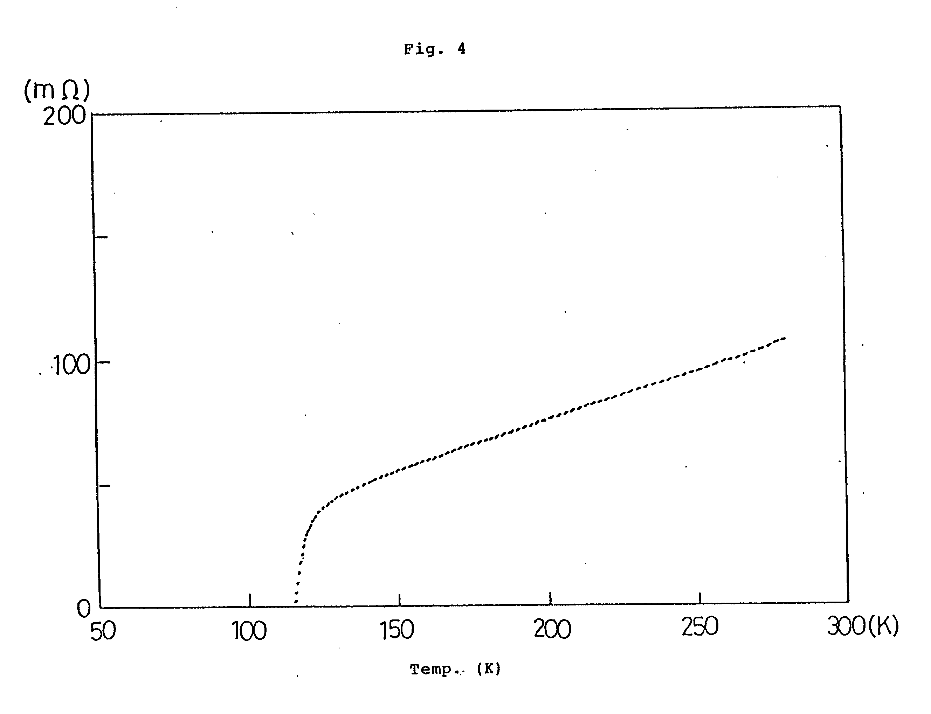

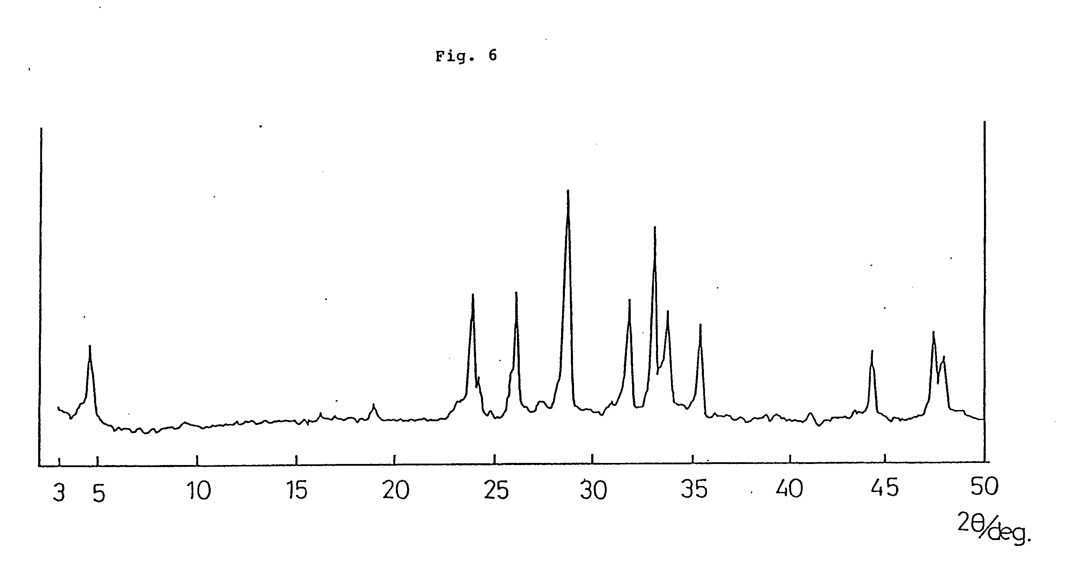

The temperature dependence of the electrical resistance of this sample is shown in Fig. 4, from which it is understood that the electrical resistance quickly dropped from about 130 K and reached 0 (zero) at about 114 K. The A.C. magnetic susceptibility of this sample is shown in Fig. 5, which confirms that this sample could be superconductive at about 114 K or higher. The X-ray diffraction pattern of this sample is shown in Fig. 6, which indicates that the percentage of the high $T_c$ phase with the c axis of 37 Å was about 90 %.

Example 3

In the same manner as in Example 2 but sintering the pressed pellet at 855°C for 120 hours, the sample was prepared in which the molar ratio of Bi:Pb:Sr:Ca:Cu was 0.82:0.09:1.17:1.15:2.00.

The zero resistance critical temperature of this sample was 112 K, and the A.C. magnetic susceptibility of this sample confirmed that this sample was superconductive at about 114 K or higher. The X-ray diffraction pattern of this sample indicated that the percentage of the high $T_c$ phase was about 80 %.

## Example 4

In the same manner as in Example 2 but coprecipitating the oxalates in the molar ratio of Bi:Pb:Sr:Ca:Cu of 1.02:0.57:1.30:1.30:2.00, the sample was prepared. According to the ICAP analysis, the molar ratio of Bi:Pb:Sr:Ca:Cu in the sample was 0.95:0.09:1.25:1.24:2.00.

The electric resistance of this sample sharply dropped from about 130 K and reached 0 (zero) at 112 K. The X-ray diffraction pattern of this sample indicated that the percentage of the high $T_c$ phase was larger than about 80 %.

## Example 5

In the same manner as in Example 3 but coprecipitating the oxalates in the molar ratio of Bi:Pb:Sr:Ca:Cu of 0.92:0.50:1.20:1.20:2.00, the sample was prepared. According to the ICAP analysis, the molar ratio of Bi:Pb:Sr:Ca:Cu in the sample was 0.87:0.07:1.17:1.15:2.00.

The electric resistance of this sample sharply dropped from about 130 K and reached 0 (zero) at 112 K. The X-ray diffraction pattern of this sample indicated that the percentage of the high $T_c$ phase was larger than about 80 %.

## Examples 6, 7 and 8

$Bi_2O_3$, $PbO$, $SrCO_3$, $CaCO_3$ and $CuO$ were weighed in a molar ratio of Bi:Pb:Sr:Ca:Cu of
1.08:0.50:1.30:1.30:2.00 (Example 6)
0.85:0.40:1.15:1.15:2.00 (Example 7)
or 0.81:0.45:1.15:1.15:2.00 (Example 8)
and ground and mixed in an agate mortar. Then, the ground mixture was placed in an alumina boat and heated and reacted with an electric furnace in the air at 800°C for 24 hours. The mixture was again ground in the mortar and pressed under pressure of about 600 $kg/cm^2$ to produce a pellet of about 20 mm in diameter and 2 mm in thickness. The pellet was sin tered with the electric furnace in the air at 855°C for 120 hours.

With the sintered sample, the molar ratio of the component elements was examined with ICAP to find that the molar ratio of Bi:Pb:Sr:Ca:Cu was
1.01:0.18:1.27:1.25:2.00 (Example 6),
0.80:0.14:1.10:1.09:2.00 (Example 7)
or 0.76:0.16:1.11:1.10:2.00 (Example 8).
when normalized with the mole number of Cu of 2.

The electrical resistance of each sample quickly dropped from about 130 K and reached 0 (zero) at about 112 K, about 111 K and about 110 K in Examples 6, 7 and 8, respectively. The A.C. magnetic susceptibility of each sample confirmed that this sample could be superconductive at the respective critical temperature or higher. The X-ray diffraction pattern of each sample indicated that the percentage of the high $T_c$ phase was about 80 %.

## Example 9

To a solution of nitrates of Bi, Pb, Sr, Ca and Cu, ammonium oxalate was added to coprecipitate oxalates in which the molar ratio of Bi:Pb:Sr:Ca:Cu was 1.15:0.30:1.30: 1.30:2.00. The coprecipitated oxalates were dried at 100°C, heated at 500°C to decompose them and ground followed by heating with an electric furnace in the air at 800°C for 12 hours. Thereafter, the mixture was again ground and pressed under pressure of about 600 $kg/cm^2$ to produce a pellet of 20 mm in diameter and 2 mm in thickness. The pellet was sintered with the electric furnace in the air at 850°C for 24 hours. The grinding and pressing were repeated and the pellet was again sintered with the electric furnace in the air at 850°C for 48 hours.

With the sintered sample, the molar ratio of the component elements was examined with ICAP to find that the molar ratio of Bi:Pb:Sr:Ca:Cu was 1.098:0.153:1.266:1.243: 2.00 when normalized with the mole number of Cu of 2.

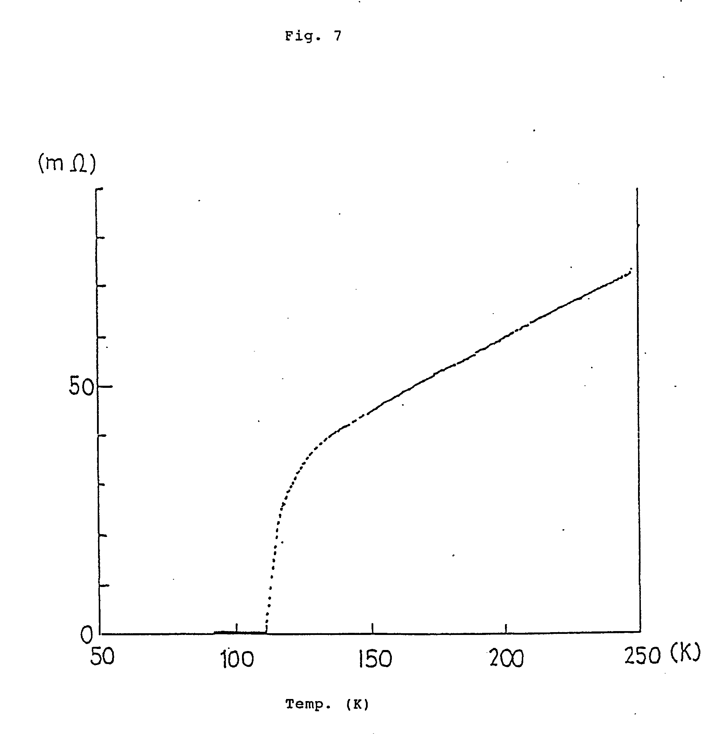

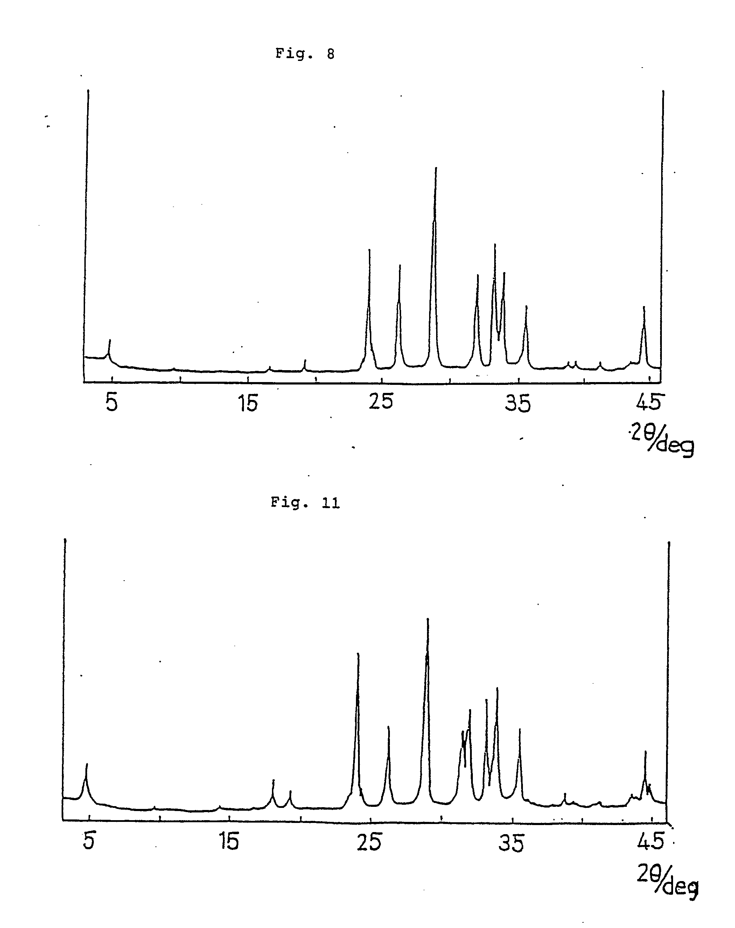

The temperature dependence of the electrical resistance of this sample is shown in Fig. 7, from which it is understood that the electrical resistance quickly dropped from about 130 K and reached 0 (zero) at about 111 K. The X-ray diffraction pattern of this sample is shown in Fig. 8, which indicates that the percentage of the high $T_c$ phase with the c axis of 37 Å was about 98 %.

## Example 10

To a solution of nitrates of Bi, Pb, Sr, Ca and Cu, ammonium oxalate was added to coprecipitate oxalates in which the molar ratio of Bi:Pb:Sr:Ca:Cu was 1.10:0.35:1.32: 1.32:2.00. The coprecipitated oxalates were dried at 100°C, heated at 500°C to decompose them and ground followed by heating with an electric furnace in the air at 800°C for 12 hours. Thereafter, the heated mixture was again ground and pressed under pressure of about 1000 $kg/cm^2$ to produce a pellet of 20 mm in diameter and 2 mm in thickness. The pellet was sintered with the electric furnace in the air at 850°C for 120 hours.

With the sintered sample, the molar ratio of the component elements was examined with ICAP to find that the molar ratio of Bi:Pb:Sr:Ca:Cu was 1.075:0.165:1.298:1.285: 2.00 when normalized with the mole number of Cu of 2.

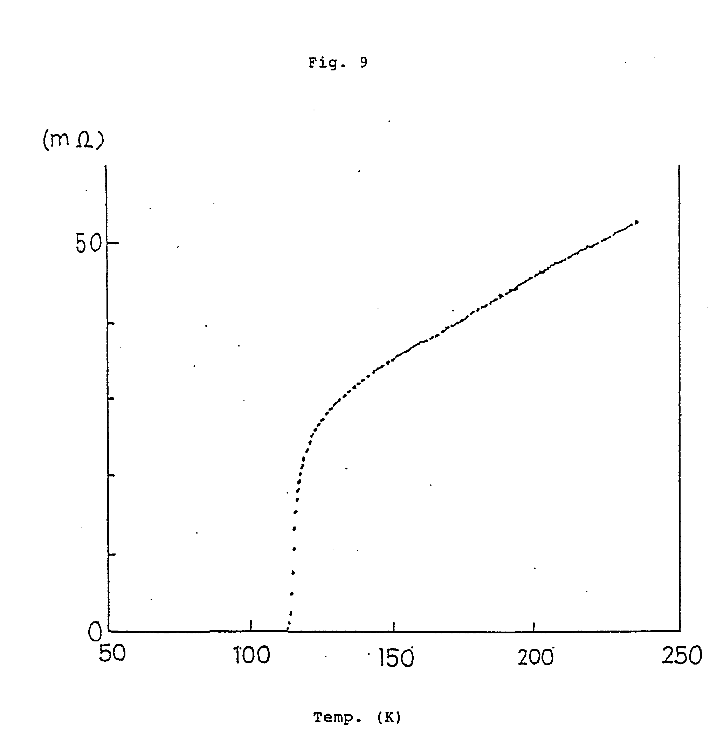

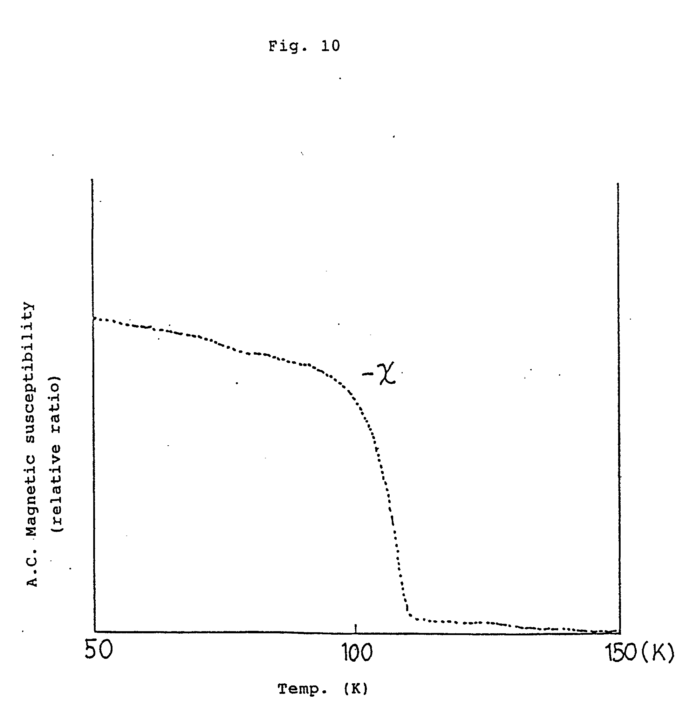

The temperature dependence of the electrical resistance of this sample is shown in Fig. 9, from which it is understood that the electrical resistance quickly dropped from about 130 K and reached 0 (zero) at about 112 K. The A.C. magnetic susceptibility of this sample is shown in Fig. 10, which confirms that this sample could be superconductive at about 112 K or higher. The X-ray diffraction pattern of this sample is shown in Fig. 11, which indicates that the percentage of the high $T_c$ phase with the c axis of 37 Å was about 90 %.

Example 11

In the same manner as in Example 9 but coprecipitating the oxalates in the molar ratio of Bi:Pb:Sr:Ca:Cu of 1.10:0.26:1.25:1.25:2.00, the sample was prepared. According to the ICAP analysis, the molar ratio of Bi:Pb:Sr:Ca:Cu in the sample was 1.058:0.168:1.221:1.213:2.00.

The sample had the zero resistance critical temperature of 108 K. The X-ray diffraction pattern of this sample indicated that the percentage of the high $T_c$ phase was about 80 %.

Example 12

In the same manner as in Example 9 but coprecipitating the oxalates in the molar ratio of Bi:Pb:Sr:Ca:Cu of 1.18:0.34:1.25:1.35:2.00, the sample was prepared. According to the ICAP analysis, the molar ratio of Bi:Pb:Sr:Ca:Cu in the sample was 1.145:0.204:1.203:1.313:2.00.

The sample had the zero resistance critical temperature of about 108 K. The X-ray diffraction pattern of this sample indicated that the percentage of the high $T_c$ phase was about 90 %.

Claims

1. A Bi-Pb-Sr-Ca-Cu-O system superconductor having a composition of
$Bi_nPb_mSr_xCa_yCu_2$
wherein n is a number from 0.75 to 1.05, m is a number from 0.01 to 0.20, x is a number from 0.85 to 1.35 and y is a number from 1.00 to 1.35, or n is a number larger than 1.05 and not larger than 1.15, m is a number from 0.12 to 0.25, x is a number from 1.20 to 1.35 and y is a number from 1.20 to 1.35, when they are normalized with the Cu mole number of 2.

2. The Bi-Pb-Sr-Ca-Cu-O system superconductor of claim 1, wherein n is a number from 0.80 to 0.95, m is a number from 0.04 to 0.20, x is a number from 0.90 to 1.30 and y is a number from 1.00 to 1.30.

3. The Bi-Pb-Sr-Ca-Cu-O system superconductor of claim 1, wherein n is a number larger than 1.05 and not larger than 1.12, m is a number from 0.15 to 0.23, x is a number from 1.25 to 1.35 and y is a number from 1.25 to 1.35.

Fig. 1

EP 0 400 666 A2

Fig. 2

Fig. 5

Fig.3

EP 0 400 666 A2

2θ/deg.

Fig. 4

Fig. 6

2θ/deg.

Fig. 7

Temp. (K)

Fig. 8

Fig. 11

Fig. 9

Temp. (K)

Fig. 10